# EUROPÄISCHE PATENTANMELDUNG

(11) **EP 1 288 348 A2**
(43) Veröffentlichungstag der Anmeldung: **05.03.2003**
(21) Anmeldenummer: 02019475.9
(22) Anmeldetag: 30.08.2002
(51) Int. Cl.: C30B 29/12, C30B 11/00

(54) **Verfahren zur Herstellung bruchfester Calciumfluorid-Einkristalle sowie deren Verwendung**

(30) Priorität: 31.08.2001 DE 10142649
(71) Anmelder: Schott Glas, 55122 Mainz (DE); CARL-ZEISS-STIFTUNG trading as SCHOTT GLAS, 55122 Mainz (DE); CARL ZEISS SEMICONDUCTOR MANUFACTURING TECHNOLOGIES AG, 73447 Oberkochen (DE)
(72) Erfinder: Kandler,Jörg Dr., 07749 Jena (DE); Mörsen,Ewald Dr., 55130 Mainz (DE); Speit,Burkhard Dr., 55126 Mainz (DE); Bauer, Harry, 73432 Aalen-Ebnat (DE); Böhm,Thure, 73430 Aalen (DE); Eva, Eric, 73432 Aalen (DE); Thier,Michael, 73563 Mögglingen (DE); Wang,Hexin Dr., 89552 Königsbronn (DE); Paus, Hans-Josef Prof., 70376 Stuttgart (DE)
(74) Vertreter: Fuchs Mehler Weiss & Fritzsche, Patentanwälte

(57) **Zusammenfassung**

Es wird ein Verfahren zur Herstellung von bruchfesten, großformatigen Calciumfluorid-Einkristallen beschrieben, die für optische Bauteile im tiefen UV-Bereich geeignet sind. Das CaF₂-Rohmaterial wird zunächst aufgeschmolzen. Anschließend erstarrt die Schmelze unter Abkühlen zu einem Einkristall. Dabei wird dem CaF₂-Rohmaterial, das als Verunreinigung Natrium in einer Menge zwischen 1 und 10 ppm enthalten kann, zwischen 1 und 250 ppm, vorzugsweise zwischen 1 und 100 ppm, Strontium zudotiert.

## Beschreibung

Die Erfindung betrifft ein Verfahren zur Herstellung bruchfester Calciumfluorid-Einkristalle, sowie die Verwendung der damit erhaltenen Kristalle.

Einkristalle aus Calciumfluorid werden unter anderem wegen ihrer optischen Eigenschaften, das heißt insbesondere wegen ihrer Durchlässigkeit für ultraviolette Strahlung, als Ausgangsmaterial für optische Komponenten in der DUV-Photolithographie benötigt, bei der mit im tiefen Ultraviolett (DUV = Deep UV) mit einer Wellenlänge λ kleiner 250 nm strahlenden Lichtquellen wie Excimerlasern feine Muster auf mit Photolack beschichtete Halbleiterwafer und dergleichen aufgebracht werden. Dazu ist es notwendig, daß die Bauteile wie Linsen oder Prismen aus dem Calciumfluorid eine sehr hohe optische Homogenität aufweisen. Fehler im Calciumfluoridkristall stören die optische Homogenität; das Calciumfluorid zeigt dann auch Spannungsdoppelbrechung. Calciumfluoridkristalle mit Fehlern und erst recht solche mit Spannungsdoppelbrechung sind natürlich nicht dafür geeignet, daraus optische Bauteile herzustellen. Solche Kristallfehler gehen in der Regel von Fremdatomen, d. h. von Verunreinigungen aus, welche in das Kristallgitter eingebaut sind und somit dessen Homogenität stören. Es wird daher angestrebt, Einkristalle für optische Elemente aus möglichst reinem Material herzustellen.

So beschreibt beispielsweise die JP-A-10-059799 die Auswirkungen von Strontium in Calciumfluoridkristallen. Danach soll der Strontiumgehalt unter 1 x 10¹⁸ Atome/cm³ gehalten werden, damit sich die optischen Eigenschaften des Calciumfluorids nicht verschlechtern. Andererseits gibt die JP-A-09-315815 an, daß ein Strontiumgehalt von 1 - 600 ppm bei einer Lanthan- und Yttriumverunreinigung von weniger als 1 bzw. 10 ppm verhindern soll, daß die Durchlässigkeit des Calciumfluoridkristalls bei der Bestrahlung mit intensivem Laserlicht im UV-Bereich, wie es bei der eingangs beschriebenen Verwendung dieser Kristalle der Fall ist, erheblich abnimmt.

Calciumfluoridkristalle werden nach einem der üblichen Kristallzuchtverfahren, etwa dem Stockbarger-Bridgman-Verfahren oder dem VGF-Verfahren (VGF = Vertical Gradient Freezing, Abkühlen im vertikalen Temperaturgradienten) als relativ große Einkristalle mit Abmessungen im Dezimeterbereich mit sehr großer Reinheit hergestellt. Diese großen Ausgangskristalle werden dann durch Sägen, Schleifen usw. in die für die optischen Bauteile erforderliche Form gebracht und schließlich durch spezielle Behandlungen wie Oberflächenveredlung und dergleichen daraus die fertigen optischen Komponenten hergestellt.

Es hat sich nun gezeigt, daß insbesondere bei hochreinen Calciumfluoridkristallen die Bruchhäufigkeit der Kristalle bei der Bearbeitung relativ hoch ist. Dabei ist es nicht nur ärgerlich, wenn ein fast fertiges Bauteil bei einem der letzten Bearbeitungsschritte in mehrere Teile zerbricht, sondern es reicht aus, daß im Kristall im Laufe der Bearbeitung Versetzungen und Mikrorisse entstehen, die schließlich dazu führen können, daß das fertige Bauteil eine verringerte optische Durchlässigkeit aufweist.

Die Bruchenergie der Calciumfluoridkristalle beträgt entlang der 111-Flächen lediglich 490 mJ/m², was extrem niedrig ist. Ähnlich niedrige Werte weist etwa Schiefer auf; die Bruchenergie beträgt im Vergleich dazu zum Beispiel in Quarz 4 300 mJ/m².

Zur Herstellung der optischen Bauteile wie Linsen wird der Rohkristall geschnitten, geschliffen und poliert. Bei diesen Schritten wird mechanisch auf das Kristallgefüge des Kristalls eingewirkt. Beim Calciumfluorid verläuft die optische Achse der Linsen entlang der Oberflächennormalen der <111> Ebene. Bei jeder Bearbeitung der gekrümmten Linsenober- fläche treten starke Scherkräfte auf, die entlang der <111> Ebene wirken. Dadurch erleidet der Kristall mikroskopisch wie makroskopisch Schaden in Form von Versetzungen und auch Rissen.

Es wurde bereits versucht, die optische Achse von Linsen abweichend von der <111> -Oberflächennormalen in einer etwas dagegen versetzten Orientierung verlaufen zu lassen. Bei Abweichung der optischen Achse von der <111>-Orientierung tritt allerdings die Härteanisotropie in der Bearbeitung stärker zum Vorschein, was die Probleme bei der Bearbeitung nur erhöht. So ergaben sich z. B. bei größeren Abweichungen zusätzlich Probleme mit der Spannungsdoppelbrechung.

Aufgabe der Erfindung ist es daher, ein Verfahren zur Herstellung eines Calciumfluorid-Einkristalls mit hoher Bruchfestigkeit zu schaffen.

Diese Aufgabe wird gemäß Patentanspruch 1 dadurch gelöst, daß dem Calciumfluorid-Rohmaterial, aus dem der Einkristall gezüchtet wird, Strontium in einer Menge zwischen 1 und 250 ppm zudotiert wird.

Die Erfindung betrifft daher auch die Verwendung von Strontium in einer Menge von 1 - 250 ppm zur Erhöhung der Bruchfestigkeit von CaF₂-Kristallen, insbesonders Einkristallen.

Vorteilhafte Ausgestaltungen des erfindungsgemäßen Verfahrens sind in den Unteransprüchen genannt.

Erfindungsgemäß wurde überraschenderweise gefunden, daß bereits durch die geringe Zudotierung von 1 bis 250 ppm Strontium, vorzugsweise 10 bis 100 ppm Strontium, zu dem Calciumfluorid-Rohmaterial sich die Bruchfestigkeit des aus diesem Rohmaterial hergestellten Einkristalls um 10 - 15 % erhöht. Entsprechend weniger Versetzungen und Mikrorisse entstehen bei einer Bearbeitung auch in dem Einkristall. Das Strontium wird in Form seiner Salze, insbesondere Halogenide oder auch als Oxid, zugesetzt. Ein besonders bevorzugtes Salz ist Fluorid.

Am besten erfolgt die Zudotierung von Strontium in einer Menge von 80 - 140 ppm, üblicherweise etwa 100 ppm. Allein durch diese geringe Menge von 100 ppm läßt sich eine Erhöhung der Bruchenergie auf 560 mJ/m² erzielen. Durch diese Erhöhung wird der Verlust durch Brechen des Kristalls beim Bearbeiten beachtlich verringert, wodurch sich die Ausbeute drastisch erhöht.

Eine weitere Zugabe auf 200 ppm Strontium zum Beispiel ergibt lediglich eine weitere Erhöhung der Bruchenergie um 10 mJ/m² auf 570 mJ/m².

Erfindungsgemäß hat es sich gezeigt, daß die geringe Zugabe von Strontium die optischen Eigenschaften des Calciumfluorid-Einkristalls nicht negativ beeinflußt.

Beim Einbringen von zusätzlichen Verunreinigungen, wie es Sr-Verbindungen sind, in den Calciumfluorideinkristall ist eigentlich zu erwarten, daß sich die Zahl der Fehl- und Störstellen im Kristallgitter erhöht und sich damit die Eigenschaften des Kristalls verschlechtern. Statt dessen tritt hier bei der Zugabe von Strontium das Gegenteil ein, nämlich eine deutliche Verringerung der Bruchanfälligkeit des Kristalls und damit verbunden eine Stabilisierung der optischen Eigenschaften des Kristalls.

Im Rohmaterial für den Calciumfluoridkristall können als Verunreinigungen insgesamt bis zu etwa 100 ppm Fremdatome wie Na, K, Li, Mg und Ba enthalten sein. Andere Verunreinigungen liegen im wesentlichen unter 1 ppm. Auch die erstgenannten Verunreinigungen lassen sich durch eine spezielle Verfahrensführung bei der Kristallzucht, bei der diese Verunreinigungen verdampfen, auf unter 1 ppm pro Element drücken. Dies gilt auch für Natrium. Natrium ist jedoch ein Element, das der Mensch in relativ großen Mengen über die Haut abgibt. Menschen sind gewissermaßen immer von einem Natriumdunst umgeben. Bei der Bearbeitung des Calciumfluorids, bei der es sich unvermeidlich immer wieder in der Nähe von Menschen befindet, erhöht sich daher die Na-Konzentration z. B. auf der Oberfläche wieder auf 2 ppm und mehr.

Interessanterweise verändert nun eine Zugabe von Matrium bzw. die Erhöhung des Natriumgehalts bei dem wie oben angegeben mit Strontium dotierten Calciumfluoridkristall die Bruchenergie kaum. Andererseits kompensiert das Strontium die negativen Auswirkungen einer Natriumverunreinigung.

Das Calciumfluorid-Rohmaterial für die Herstellung des Einkristalls kann daher als Verunreinigung zwischen etwa 1 und 10 ppm Natrium enthalten.

Die Erhöhung der mechanischen Festigkeit des Calciumfluoridkristalls durch die extrem geringe Menge von weniger als 250 ppm, vorzugsweise weniger als 200 ppm, üblicherweise etwa 100 ppm Strontium ist deshalb um so überraschender, als normalerweise derartige Effekte an Kristallen erst bei Dotierungen von mehreren Prozent, in der Regel mindestens 2 - 3 %, erhalten werden. Eine weitere wichtige Tatsache, die die Verwendung des Strontiums begünstigt, liegt darin, daß sich Strontium im Kristall nicht anreichert, sondern bei der Kristallisation homogen verteilt bleibt. Diese homogene Verteilung des Strontiums ist für die Erhöhung der mechanischen Festigkeit unbedingt erforderlich.

Die Erfindung wird an Hand der folgenden Ausführungsform näher beschrieben.

Ein großformatiger Einkristall aus CaF₂ mit einem Durchmesser von 25 cm wird in einem rohrförmigen, mit einem Deckel verschlossenen Tiegel hergestellt, wobei ein rotationssymmetrisches Temperaturprofil und der Tiegel in Richtung Tiegelboden zu Tiegelöffnung relativ zueinander bewegt werden, so daß das CaF₂-Rohmaterial, aus dem der Einkristall erschmolzen wird, zunächst aufschmilzt und anschließend im abfallenden Teil des Temperaturprofils zu einem Einkristall erstarrt, wie dies zum Beispiel in der PCT/DE01/00789 beschrieben ist. Der Einkristall ist für die Herstellung von optischen Bauteilen für den DUV-Bereich (λ < 250 nm; DUV = Deep UV) vorgesehen.

CaF₂-Einkristalle werden im allgemeinen in einem rohrförmigen Ziehofen unter Vakuum bei 10⁻⁴ bis 10⁻⁷ mbar nach dem Stockbarger-Bridgman- oder dem Vertical-Gradient-Freeze-Verfahren (VGF) hergestellt. Dabei wird der mit dem Rohmaterial für den Kristall gefüllte Tiegel über seine Länge mit einem Temperaturgradienten in vertikaler und (rotationssymmetrisch) in horizontaler Richtung beaufschlagt, um das Material zuerst aufzuschmelzen und dann bei einem geringen Temperaturgradienten erstarren zu lassen. Der vertikale Gradient soll eine im wesentlichen ebene Kristallisationsfront gewährleisten. In der Regel befindet sich am Boden des Tiegels ein Impfkristall. Dort ist die Temperatur am niedrigsten. Die Kristallisation beginnt am Impfkristall, wenn die Temperatur der CaF₂-Schmelze dort den Schmelzpunkt unterschreitet. Nach Stockbarger-Bridgman wird der Tiegel mechanisch durch ein dem Ziehofen eingeprägtes Temperaturprofil bewegt, nach dem neueren VGF-Verfahren wird das Temperaturprofil eines Gradienten-Rohrofens elektrisch (mit einer Geschwindigkeit von etwa 1 mm/Stunde) am ruhenden Tiegel vorbeibewegt. Die Herstellungsdauer für einen CaF₂-Einkristall mit einer Höhe von 200 - 400 mm und einem Durchmesser von etwa 250 mm für optische Bauteile beträgt mehrere Wochen.

Nur die genaueste Einhaltung der Temperatur von etwa 1400°C im Bereich der Kristallisationsfront (erlaubte Temperaturschwankungen < 1°C in axialer und < 5°C in radialer Richtung) und eine ausreichende Verweildauer bei dieser Temperatur gewährleisten die Entstehung eines hochhomogenen Einkristalls mit Brechungsindexschwankungen Δn < 1 x 10⁻⁶. Störungen der Homogenität zeigen sich auch in einer Spannungsdoppelbrechung, die den Kristall für die gewünschten optischen Zwecke unbrauchbar macht.

Die aus den CaF₂-Einkristallen hergestellten Bauteile - es handelt sich dabei vorwiegend um Linsen, Prismen und optische Fenster - werden zum Beispiel in optischen Geräten für die DUV-Photolithographie wie Stepper und Excimerlaser eingesetzt.

Stepper sind Vorrichtungen, mit denen die Strukturen integrierter Schaltungen optisch auf photolackbeschichtete Halbleiterwafer abgebildet werden. Um die geforderten feinen Strukturen (die Strukturbreiten betragen derzeit um 0,25 µm) abbilden zu können, muß das optische Bauteil eine hohe Homogenität aufweisen; die Brechzahl bzw. der Brechungsindex muß wie erwähnt über das ganze Bauteil auf Δn < 10⁻⁶ konstant sein. Als Lichtquelle werden Excimerlaser mit Wellenlängen von 193 nm oder 157 nm verwendet.

Um die Belichtungszeiten beim Belichten der photolackbeschichteten Halbleiterwafer klein zu halten, ist eine Strahlung hoher Intensität und eine hohe Lichtdurchlässigkeit der optischen Bauteile erforderlich. Kurze Belichtungszeiten bedeuten einen geringeren Zeitaufwand bei der Herstellung der Halbleiterchips und ermöglichen eine hohe Ausnutzung der Anlagen für die Chipherstellung.

Die Durchlässigkeit der CaF₂-Einkristalle im DUV-Bereich kann sich auch noch nachträglich verändern. Wenn in den Kristall etwa durch die Bearbeitung mikroskopische Fehler eingebracht werden, verschlechtert sich das Transmissionsverhalten des Kristalls.

Jede Störung der regulären Kristallstruktur wie Fehlstellen, Versetzungen und Fremdatome im Kristallgitter erhöht auch die Empfindlichkeit gegenüber Strahlenschäden durch harte Strahlung, wie es das intensive UV-Licht von Excimerlasern darstellt. Es entstehen dabei lichtabsorbierende Farbzentren im Kristall, die seine Durchlässigkeit vermindern.

Fremdatome wie Na, K, Li, Mg und Ba können in der Summe bis zu einem Gehalt von 100 ppm in CaF₂ vorkommen. Durch besondere Maßnahmen, wie z. B. das Reinigen der Ausgangssubstanzen und/oder die Verwendung von Scavenger bei der Kristallzüchtung, läßt sich der Fremdatomgehalt unter weniger als 1 ppm verringern. Die Herstellung eines CaF₂-Einkristalls durchläuft dazu sechs Phasen:
1. Der Tiegel mit dem CaF₂-Rohmaterial wird langsam auf die Desorptionstemperatur des Wassers von etwa 400°C bis 600°C aufgeheizt und einige Zeit bei dieser Temperatur belassen, um das Rohmaterial zu entwässern.
2. Anschließend wird die Temperatur innerhalb eines Zeitraums von etwa 20 Stunden auf etwa 1450°C erhöht; in dieser Phase erfolgt die Entfernung des Sauerstoffs aus dem Rohmaterial. Dazu werden dem Rohmaterial Fluoride wie PbF₂, SnF₂ oder ZnF₂ beigemischt, die eine hohe Affinität zu Sauerstoff haben und die mit dem im Rohmaterial enthaltenen Sauerstoff zum entsprechenden leichtflüchtigen Oxid reagieren. Die nicht verbrauchten beigemischten Fluoride verdampfen bei dieser Temperatur schließlich ebenfalls vollständig. Dieser Vorgang wird Scavenger-Prozeß genannt.
3. Nun erfolgt für etwa eine Woche bei 1450°C ein Verdampfen der Fremdatomverbindungen zusammen mit CaF₂, wobei die Gesamtmasse der verdampften Substanzen die Fremdatomfreiheit des Einkristalls bestimmt. Für jede Kristallzuchtanlage gibt es, abhängig vom eingesetzten Rohstoff und vom Aufbau der Anlage, eine Mindestmasse von zu verdampfenden Material, um einen Einkristall mit der geforderten Reinheit zu erhalten.
4. Anschließend läuft in einer etwa zweiwöchigen Phase die eigentliche Kristallzucht ab, während der die Temperatur allmählich auf etwa 1200°C heruntergefahren wird.
5. und 6. Der entstandene Kristall wird dann in zwei Stufen auf Raumtemperatur abgekühlt.

Bei dem beschriebenen Verfahren wird nun dem CaF₂-Rohmaterial zwischen 1 und 250 ppm Sr, vorzugsweise zwischen 10 und 200 ppm Sr und am besten etwa 100 ppm Sr zudotiert.

Das Sr wird dem Rohmaterial vorzugsweise als SrF₂ zugefügt.

Auch eine vergleichsweise hohe Verunreinigung des CaF₂-Einkristalls besonders in Form eines hohen Na-Gehalts zwischen etwa 1 und 10 ppm hat dann keinen Einfluß mehr auf die Eigenschaften des Kristalls.

Zum Herstellen von Linsen etc. aus dem Rohkristall werden die Fertigungsschritte Sägen/Schneiden, Schleifen/Läppen und Polieren durchlaufen. Diese Schritte beinhalten starke mechanische Einwirkungen auf das Kristallgefüge des CaF₂ mit seiner geringen Bruch- oder Oberflächenergie von ca. 490 mJ/m². Das CaF₂ spaltet bevorzugt entlang der 111-Flächen, die zudem noch identisch mit den Oberflächen der Linsen sind, so daß bei jeder Bearbeitung mechanische Kräfte parallel zu den Oberflächen wirksam werden. So kommt es bei der Bearbeitung der 111-Flächen leicht zum Spalten und somit zum Ausfall des Materials.

Durch die Zugabe des Strontiums wird nun die Bruchfestigkeit des Kristalls um 10- 15 % erhöht.

Die Zunahme der Festigkeit parallel zur 111-Fläche wird wie folgt bestimmt: An Würfeln mit 15 mm Kantenlänge werden die Oberflächen geschliffen und poliert. Die Ober- und die Unterseite des Würfels sind dabei 111-Flächen. Die Würfel werden auf einem Tisch gegen Verrücken fixiert und seitlich solange ein Stempel gegen die obere Hälfte der Seitenfläche verfahren, bis ein Bruch eintritt.

Die Erfindung betrifft auch die Verwendung solcher erfindungsgemäß erhaltenen Einkristalle zur Herstellung von optischen Elementen für die DUV-Lithographie sowie zur Herstellung von mit Photolack beschichteten Wafern und somit zur Herstellung von elektronischen Geräten.

Die Erfindung betrifft daher auch die Verwendung der mittels des erfindungsgemässen Verfahrens und/oder in der erfindungsgemäßen Vorrichtung erhaltenen Einkristalle zur Herstellung von Linsen, Prismen, Lichtleitstäben, optischen Fenstern sowie optischen Geräten für die DUV-Lithographie insbesondere zur Herstellung von Steppern und Excimerlasern und somit auch zur Herstellung von integrierten Schaltungen sowie elektronischer Geräte wie Computerchips enthaltenden Computern sowie andere elektronische Geräte, welche chipartige integrierte Schaltungen enthalten.

## Patentansprüche

1. Verfahren zur Herstellung von bruchfesten großformatigen Calciumfluorid-Einkristallen für optische Bauteile durch Aufschmelzen von CaF₂-Rohmaterial und anschließend Abkühlen unter Erstarren der Schmelze zu einem Einkristall, **dadurch gekennzeichnet, daß** dem CaF₂-Rohmaterial zur Erhöhung der Bruchfestigkeit des Kristalls zwischen 1 und 250 ppm Strontium zudotiert wird.

2. Verfahren nach Anspruch 1, **dadurch gekennzeichnet, daß** dem CaF₂-Rohmaterial 10 bis 200 ppm Strontium zudotiert wird.

3. Verfahren nach einem der vorhergehenden Ansprüche, **dadurch gekennzeichnet, daß** dem CaF₂-Rohmaterial 80 bis 140 ppm Strontium zudotiert wird.

4. Verfahren nach einem der vorhergehenden Ansprüche, **dadurch gekennzeichnet, daß** das Strontium dem CaF₂-Rohmaterial als SrF₂ zugefügt wird.

5. Verfahren nach einem der vorhergehenden Ansprüche, **dadurch gekennzeichnet, daß** das CaF₂-Rohmaterial als Verunreinigung zwischen 1 und 10 ppm Natrium enthält.

6. Verfahren nach einem der vorhergehenden Ansprüche, **dadurch gekennzeichnet, daß** das CaF₂-Rohmaterial bis zu 100 ppm weitere Verunreinigungen wie K-, Li-, Mg- und Ba-Fremdatome enthält.

7. Verwendung von nach einem der vorhergehenden Ansprüche erhaltenen Calciumfluorid-Einkristall zur Herstellung von Linsen, Prismen, Lichtleitstäben, optischen Fenstern sowie optischen Komponenten für die DUV-Fotolithographie, Steppern, Excimerlasern, Wafern, Computerchips, sowie integrierten Schaltungen und elektronischen Geräten, die solche Schaltungen und Chips enthalten.
